(19) Europäisches Patentamt / European Patent Office / Office européen des brevets

(11) **EP 4 206 293 A1**

(12) **EUROPEAN PATENT APPLICATION**
published in accordance with Art. 153(4) EPC

(43) Date of publication:
**05.07.2023 Bulletin 2023/27**

(21) Application number: **21861685.2**

(22) Date of filing: **26.08.2021**

(51) International Patent Classification (IPC):
**C09J 1/00** (2006.01)     **C09J 9/02** (2006.01)
**H01B 1/00** (2006.01)     **H01B 1/22** (2006.01)
**H01L 21/52** (2006.01)

(52) Cooperative Patent Classification (CPC):
**C09J 1/00; C09J 9/02; H01B 1/00; H01B 1/22; H01L 21/52**

(86) International application number:
**PCT/JP2021/031411**

(87) International publication number:
**WO 2022/045263 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.08.2020 JP 2020145153**

(71) Applicant: Osaka Soda Co., Ltd.
**Osaka-shi**
**Osaka 550-0011 (JP)**

(72) Inventors:
• **OKUDA, Masatoshi**
**Osaka-shi, Osaka 550-0011 (JP)**
• **MORI, Takamichi**
**Osaka-shi, Osaka 550-0011 (JP)**
• **KATOU, Ryo**
**Osaka-shi, Osaka 550-0011 (JP)**
• **MINAMI, Junichirou**
**Osaka-shi, Osaka 550-0011 (JP)**

(74) Representative: **Müller-Boré & Partner**
**Patentanwälte PartG mbB**
**Friedenheimer Brücke 21**
**80639 München (DE)**

(54) **ELECTROCONDUCTIVE ADHESIVE**

(57)     Provided is an electroconductive adhesive with which, when made into an electroconductive adhesive and sintered suitably at low temperature even without pressurization during sintering of the electroconductive adhesive, a sintered body having high denseness and mechanical strength (shear strength) is formed. An electroconductive adhesive containing silver particles A having an average particle size of less than 40 nm, silver particles B having an average particle size in the range of 40 nm to less than 500 nm, silver particles C having an average particle size in the range of 0.5 to less than 5.5 $\mu$m, and a solvent, wherein the mass ratio of silver particles A : silver particles B : silver particles C is 1-20 : 30-60 : 40-70.

FIG. 1

## Description

### TECHNICAL FIELD

The present invention relates to an electroconductive adhesive, a sintered body of the electroconductive adhesive, a method for producing the sintered body, an electronic component including the sintered body between members, and a method for manufacturing the electronic component.

### BACKGROUND ART

Electroconductive adhesive such as a die bonding agent are joining materials used for electronic components such as semiconductors, LEDs, and power semiconductors. As a joining method, joining by pressurization and heating, or joining with a substrate by sintering through, for example, heating without pressurization is generally known. In recent years, a non-pressurization joining material is being developed from the viewpoint of simplicity and efficiency of its production process.

One example of the non-pressurization joining material is an electroconductive adhesive containing an epoxy resin. This joining material is used by curing the epoxy resin in a low-temperature treatment and is capable of suppressing generation of voids and improving strength of joining with a substrate (Patent Document 1). However, the epoxy resin itself becomes a resistor to lower electroconductivity and thermal conductivity obtained.

On the other hand, silver particles have been developed in recent years as a joining material not containing a thermosetting resin such as an epoxy resin. The silver particles have a feature of being easily sintered by a heat treatment at a low temperature for a short time. For example, Patent Document 2 discloses a metal paste obtained by kneading a solid content composed of silver particles and a solvent, in which the solid content is composed of silver particles including 30% or more of silver particles having a particle size of 100 to 200 nm based on the number of particles, and the silver particles constituting the solid content are bonded with an amine compound having a total carbon number of 4 to 8 as a protective agent. According to the metal paste, the silver particles can be sintered in a low temperature range, and in addition thereto, a sintered body having low resistance and a sintered body having excellent thermal conductivity can be formed.

### PRIOR ART DOCUMENT

### PATENT DOCUMENTS

Patent Document 1: WO 2010/18712 A
Patent Document 2: Japanese Patent Laid-open Publication No. 2015-159096

### SUMMARY OF THE INVENTION

### PROBLEMS TO BE SOLVED BY THE INVENTION

In the field of electroconductive adhesives, in order to reduce voids of a sintered body obtained by applying an electroconductive adhesive to a member (such as a substrate or a semiconductor chip used for an electronic component) and sintering the electroconductive adhesive (to increase denseness), pressurizing during sintering (pressure is, for example, about 10 to 30 MPa) is generally performed. By sintering the electroconductive adhesive while pressurizing, voids of the sintered body can be reduced. When there are many voids in the sintered body, there is a problem in terms of reliability, for example, a mechanical strength (shear strength) becomes insufficient, or cracking or chipping is easily generated in the sintered body. On the other hand, there are also problems in that pressurizing during sintering gives a damage to the member coated with the electroconductive adhesive, special equipment is required for pressurizing, and the like. When the sintered body is formed on a semiconductor chip or the like having a complicated structure, there is also a problem in that the electroconductive adhesive cannot be pressurized.

In recent years, with an increase in size of a semiconductor chip, improvement in durability is required. In order to alleviate the stress applied to a joining portion between a semiconductor chip and a substrate or to the semiconductor chip itself, measures are taken such as increasing the film thickness at the time of applying the electroconductive adhesive to the substrate or increasing the film thickness of a joined body itself. Since physical property values such as Young's modulus (longitudinal elastic modulus) of a semiconductor chip, a substrate, and other members are different, and a deformation width during sintering is different, stress is applied to each material, but it is known that the joined body receives the stress by thickening the joined body. For example, in an electroconductive adhesive using solder, it is common to form a thick film for stress relaxation, but in a sintered body using silver, when the sintered body is formed into a thick film (50 $\mu$m or more) by the sintering shrinkage action of silver, a problem arises in that void generation due to difficulty in releasing outgas generated during sintering, and defects such as cracking or chipping and internal cracks of the sintered body due to shrinkage are likely to occur. In particular, in order to secure high denseness, it is necessary to use metal particles having high sinterability = high shrinkage, and it is difficult to achieve both the denseness and the film thickness. Therefore, it was not suitable to use small particles of 30 nm or less alone as a joining material.

Therefore, in recent years, there has been a demand for development of an electroconductive adhesive capable of forming a sintered body having high denseness and a high mechanical strength (shear strength) even without pressurization during sintering of the electroconductive adhesive.

The electroconductive adhesive is generally sintered at a sintering temperature of about 300°C, but there is a demand for an electroconductive adhesive that can be sintered at a lower temperature (for example, a sintering temperature of 250°C or lower), and further, does not generate defective portions such as voids, cracking or chipping, and internal cracks even when a film becomes thick (for example, 50 $\mu$m or more).

When a novel electroconductive adhesive which is suitably sintered at a low temperature even without pressurization during sintering of the electroconductive adhesive to form a sintered body having high denseness and a high mechanical strength (shear strength) and is particularly excellent in denseness and mechanical strength when a film becomes thick, the above problems can be solved.

Under such circumstances, a main object of the present invention is to provide an electroconductive adhesive which is suitably sintered at a low temperature even without pressurization during sintering of the electroconductive adhesive to form a sintered body having high denseness and a high mechanical strength (shear strength). An object of the present invention is also to provide an electroconductive adhesive in which cracking or chipping and voids or cracks are hardly generated even when a film becomes thick (50 $\mu$m or more). An object of the present invention is also to provide a sintered body of the electroconductive adhesive, and an electronic component including the sintered body between members.

MEANS FOR SOLVING THE PROBLEM

The present inventors have conducted intensive studies in order to solve the above problems. As a result, the present inventors have found that when relatively small silver particles having an average particle size in a predetermined range, relatively medium silver particles having an average particle size in a predetermined range, and relatively large silver particles having an average particle size in a predetermined range are used, and the average particle sizes of the large silver particles, the medium silver particles, and the small silver particles are combined at a specific ratio to form an electroconductive adhesive, the electroconductive adhesive is suitably sintered at a low temperature even without pressurization during sintering of the electroconductive adhesive, and a sintered body having high denseness and a high mechanical strength (shear strength) is formed. The present inventors have also found that a sintered body in which cracking or chipping and voids or internal cracks are hardly generated even when a film becomes thick. The present inventors have conducted further studies based on the findings, leading to the completion of the present invention.

That is, the present invention provides inventions of the following aspects.

Item 1. An electroconductive adhesive containing:

silver particles A having an average particle size of less than 40 nm;
silver particles B having an average particle size in a range of 40 nm or more to less than 500 nm;
silver particles C having an average particle size in a range of 0.5 $\mu$m or more to less than 5.5 $\mu$m; and
a solvent,
in which a mass ratio of the silver particles A : the silver particles B : the silver particles C is 1 to 20 : 30 to 60 : 40 to 70.

Item 2. The electroconductive adhesive described in item 1, in which an amine compound is attached to surfaces of the silver particles A and/or the silver particles B.
Item 3. A sintered body of the electroconductive adhesive described in item 1 or 2.
Item 4. An electronic component formed by joining members by the sintered body described in item 3.
Item 5. A method for producing a sintered body, the method including a step of sintering the electroconductive adhesive described in item 1 or 2 at a temperature of 200°C or higher and 250°C or lower.
Item 6. A method for manufacturing an electronic component formed by joining members by a sintered body, the method including:

a step of disposing the electroconductive adhesive described in item 1 or 2 between the members; and
a step of sintering the electroconductive adhesive at a temperature of 200°C or higher and 250°C or lower.

ADVANTAGES OF THE INVENTION

According to the present invention, it is possible to provide a novel electroconductive adhesive which is suitably sintered at a low temperature even without pressurization during sintering of the electroconductive adhesive to form a sintered body having high denseness and a high mechanical strength (shear strength). According to the present invention, by using particles having different sintering temperatures, the electroconductive adhesive is not sintered at a time, but sintering starts from particles having a low sintering temperature to gradually form a dense sintered body, and thus a sintered body having high density and a high shear strength is obtained. It is possible to form a favorable sintered body which has a suitable composition capable of suppressing sintering shrinkage during sintering and in which a defect layer (cracking or chipping, and voids or internal cracks) is hardly generated even when a film becomes thick. According to the present invention, it is also possible to provide an electroconductive adhesive containing the silver particles, a sintered body of the electroconductive adhesive, and an electronic component including the sintered body between members.

BRIEF DESCRIPTION OF THE DRAWINGS

Fig. 1 is an SEM image of silver particles A1.
Fig. 2 is an SEM image of silver particles B1.
Fig. 3 is an SEM image of silver particles B2.
Fig. 4 is an SEM image of silver particles C1.
Fig. 5 is an SEM image of silver particles C2.
Fig. 6 is an SEM image of a cross-section of a sintered body of Example 2 at a magnification of 2000.
Fig. 7 is an SEM image of the cross-section of the sintered body of Example 2 at a magnification of 100.
Fig. 8 is an SEM image of a cross-section of a sintered body of Comparative Example 2 at a magnification of 2000.
Fig. 9 is an SEM image of the cross-section of the sintered body of Comparative Example 2 at a magnification of 200.
Fig. 10 is an SEM image of a cross-section of a sintered body of Example 5 at a magnification of 2000.
Fig. 11 is an SEM image of a cross-section of a sintered body of Comparative Example 4 at a magnification of 1000.

EMBODIMENTS OF THE INVENTION

An electroconductive adhesive of the present invention contains silver particles A having an average particle size of less than 40 nm, silver particles B having an average particle size in a range of 40 nm or more to less than 500 nm, silver particles C having an average particle size in a range of 0.5 $\mu$m or more to less than 5.5 $\mu$m, and a solvent, in which a mass ratio of the silver particles A : the silver particles B : the silver particles C is 1 to 20 : 30 to 60 : 40 to 70. Since the electroconductive adhesive of the present invention has such a feature, it is possible to provide a novel electroconductive adhesive which is suitably sintered at a low temperature even without pressurization at the time of sintering the electroconductive adhesive to form a sintered body having high denseness and a high mechanical strength (shear strength).

Hereinafter, an electroconductive adhesive, a sintered body of the electroconductive adhesive, a method for producing the sintered body, an electronic component including the sintered body between members, and a method for manufacturing the electronic component of the present invention will be described in detail. In the present specification, numerical values connected with "to" refer to the numerical range including the numerical values before and after "to" as a lower limit value and an upper limit value. When a plurality of lower limit values and a plurality of upper limit values are mentioned separately, any lower limit value and any upper limit value can be selected and connected with "to".

1. Electroconductive Adhesive

An electroconductive adhesive of the present invention contains silver particles A, silver particles B, silver particles C, and a solvent. When the electroconductive adhesive contains the solvent, flowability is enhanced, and the electroconductive adhesive of the present invention is easily disposed at a desired location. Details of the silver particles contained in the electroconductive adhesive of the present invention are as described below.

Silver Particles A

The average particle size of the silver particles A of the present invention is less than 40 nm. The average particle size of the silver particles A may be less than 40 nm, but from the viewpoint of more suitably exhibiting the effects of the present invention, the lower limit is preferably 10 nm or more and more preferably 15 nm or more, the upper limit is preferably 35 nm or less, and the preferred range is 1 to 40 nm, more preferably 10 to 35 nm, further preferably 15 to 35 nm, or the like.

In the present invention, the average particle size of the silver particles A is a volume-based average particle size measured for 200 randomly selected particles in an SEM image using image analysis software (for example, Macview (manufactured by Mountech Co., Ltd.)). For the SEM observation, a range with a lateral width of 1 to 20 μm is observed at an observation magnification of 5000 to 60000 at an acceleration voltage of 20 kV using an SED mode (secondary electron detector). The longitudinal direction of the SEM image is a width in which 200 or more (usually, about 200 to 300) silver particles are included in a range with a lateral width of 1 to 20 μm. The volume-based average particle size is a value measured assuming that the particles observed in the SEM image are spherical particles having the diameters of the observed particles. A specific measurement method is as described in Examples.

A dry powder of the silver particles A of the present invention has a weight reduction rate of preferably 2.0 wt% or less and more preferably 0.05 to 1.5 wt% at the time of heating from 30°C to 500° by thermogravimetric differential thermal analysis. The method of thermogravimetric differential thermal analysis is as follows.

<Thermogravimetric Differential Thermal Analysis (TG-DTA)>

First, air dried silver particles A are prepared. For example, when silver particles are obtained from the electroconductive adhesive and analyzed, 2 g of methanol is added to 1 g of each electroconductive adhesive and sufficiently dispersed, the silver particles A are then collected by filtration and air-dried to obtain a silver particle dry powder, and the silver particle dry powder is used as an analysis target. TG-DTA of the dry powder of the silver particles A is measured with a thermogravimetric differential thermal analyzer (for example, HITACHI G300 AST-2). The measurement conditions are as follows: atmosphere: air, measurement temperature: 30 to 500°C, and temperature increase rate: 10°C/min. From the obtained TG-DTA chart, an exothermic peak attributable to binding of the silver particles in TG-DTA analysis and a weight reduction rate at the time of heating from 30°C to 500°C by thermal analysis are obtained.

From the viewpoint of more suitably exhibiting the effects of the present invention, the silver particles A are preferably surface-treated. That is, the silver particles A of the present invention are preferably surface-treated silver particles.

More specifically, it is preferable that an amine compound is attached to the surfaces of the silver particles A of the present invention. The amine compound is attached to the surfaces of the silver particles A and can form a protective layer. In the silver particles A of the present invention, it is preferable to attach the amine compound so that the average particle size is set in the above specific range.

The amine compound is not particularly limited and can include a primary amine, a secondary amine, a tertiary amine, and a diamine compound having two amino groups in one compound, from the viewpoint of more suitably exhibiting the effects of the present invention.

Examples of the primary amine include amines having a straight or branched hydrocarbon group such as monoethanolamine, ethylamine, n-propylamine, isopropylamine, 1,2-dimethylpropylamine, n-butylamine, isobutylamine, sec-butylamine, tert-butylamine, isoamylamine, n-octylamine, 2-octylamine, tert-octylamine, 2-ethylhexylamine, n-nonylamine, n-aminodecane, n-aminoundecane, n-dodecylamine, n-tridecylamine, 2-tridecylamine, n-tetradecylamine, n-pentadecylamine, n-hexadecylamine, n-heptadecylamine, n-octadecylamine, n-oleylamine, 3-methoxypropylamine, 3-ethoxypropylamine, 3-propoxypropylamine, 3-isopropoxypropylamine, 3-butoxypropylamine, N-ethyl-1,3-diaminopropane, N,N-diisopropylethylamine, N,N-dimethyl-1,3-diaminopropane, N,N-dibutyl-1,3-aminopropane, N,N-diisobutyl-1,3-diaminopropane, and N-lauryl diaminopropane.

Examples of the primary amine also include alicyclic amines such as cyclopropylamine, cyclobutylamine, cyclopropylamine, cyclohexylamine, cycloheptylamine, and cyclooctylamine, and aromatic amines such as aniline.

Examples of the primary amine also include ether amines such as 3-isopropoxypropylamine and isobutoxypropylamine.

Examples of the secondary amine include dialkylmonoamines such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, N,N-distearylamine, N-methyl-N-propylamine, N-ethyl-N-propylamine, and N-propyl-N-butylamine, and cyclic amines such as piperidine.

Examples of the tertiary amine include triethylamine, tributylamine, trihexylamine, dimethyloctylamine, dimethyldecylamine, dimethyllaurylamine, dimethylmyristylamine, dimethylpalmitylamine, dimethylstearylamine, and dilaurylmonomethylamine.

As the amine, a diamine compound having two amino groups in one compound can also be used. Examples of the diamine compound include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-propanediamine, N,N'-dimethyl-1,3-propanediamine, N,N-diethyl-1,3-propanediamine, N,N'-diethyl-1,3-propanediamine, 1,4-butanediamine, N,N-dimethyl-1,4-butanediamine, N,N'-dimethyl-1,4-butanediamine, N,N-diethyl-1,4-butanediamine, N,N'-diethyl-1,4-butanediamine, 1,5-pentanediamine, 1,5-diamino-2-methylpentane, 1,6-hexanediamine, N,N-dimethyl-1,6-hexanediamine, N,N'-dimethyl-1,6-hexanediamine, 1,7-heptanediamine, and 1,8-octanediamine.

As the amine compound on the surfaces of the silver particles A of the present invention, n-propylamine, isopropylamine, cyclopropylamine, n-butylamine, isobutylamine, sec-butylamine, tert-butylamine, cyclobutylamine, n-amylamine, n-hexylamine, cyclohexylamine, n-octylamine, 2-ethylhexylamine, n-dodecylamine, n-oleylamine, 3-methoxypropylamine, 3-ethoxypropylamine, N,N-dimethyl-1,3-diaminopropane, and N,N-diethyl-1,3-diaminopropane are preferable, and n-butylamine, n-hexylamine, n-octylamine, 3-methoxypropylamine, n-dodecylamine, N,N-dimethyl-1,3-diaminopropane, N,N-diethyl-1,3-diaminopropane, and cyclohexylamine are more preferable.

The attached amount of the amine compound of the silver particles A of the present invention is not particularly limited, but is preferably 2.0 mass% or less and more preferably 1.5 mass% or less with respect to 100 mass% of the mass of the silver particles, and the lower limit is preferably 0.05 mass% or more. The content of the amine compound attached to the silver particles A can be measured by thermogravimetric differential thermal analysis.

A fatty acid, a hydroxy fatty acid, or the like may be attached to the surfaces of the silver particles A. The fatty acid is not particularly limited, but is, for example, preferably a fatty acid having an alkyl group with 3 or more and 18 or less carbon atoms and more preferably a fatty acid having an alkyl group with 4 or more and 18 or less carbon atoms. Preferred specific examples of the fatty acid include acetic acid, propionic acid, butyric acid, valeric acid, caproic acid, caprylic acid, 2-ethylhexanoic acid, capric acid, lauric acid, myristic acid, palmitic acid, stearic acid, oleic acid, linoleic acid, and $\alpha$-linolenic acid. Specific examples of the fatty acid also include cyclic alkyl carboxylic acids such as cyclohexanecarboxylic acid. As the hydroxy fatty acid, a compound having 3 to 24 carbon atoms and one or more (for example, one) hydroxyl groups can be used. Examples of the hydroxy fatty acid include 2-hydroxydecanoic acid, 2-hydroxydodecanoic acid, 2-hydroxytetradecanoic acid, 2-hydroxyhexadecanoic acid, 2-hydroxyoctadecanoic acid, 2-hydroxyeicosanoic acid, 2-hydroxydocosanoic acid, 2-hydroxytricosanoic acid, 2-hydroxytetracosanoic acid, 3-hydroxyhexanoic acid, 3-hydroxyoctanoic acid, 3-hydroxynonanoic acid, 3-hydroxydecanoic acid, 3-hydroxyundecanoic acid, 3-hydroxydodecanoic acid, 3-hydroxytridecanoic acid, 3-hydroxytetradecanoic acid, 3-hydroxyhexadecanoic acid, 3-hydroxyheptadecanoic acid, 3-hydroxyoctadecanoic acid, co-hydroxy-2-decenoic acid, $\omega$-hydroxypentadecanoic acid, $\omega$-hydroxyheptadecanoic acid, $\omega$-hydroxyeicosanoic acid, $\omega$-hydroxydocosanoic acid, 6-hydroxyoctadecanoic acid, ricinoleic acid, 12-hydroxystearic acid, and [R-(E)]-12-hydroxy-9-octadecenoic acid. Among them, a hydroxy fatty acid having 4 to 18 carbon atoms and one hydroxyl group at a position (particularly, the 12-position) other than the $\omega$-position is preferable, and ricinoleic acid, 12-hydroxystearic acid, and oleic acid are more preferable. Each of the fatty acid and the hydroxy fatty acid may be used singly or may be used in combination of two or more kinds thereof.

In the silver particles A of the present invention, the attached amount of the fatty acid or the hydroxy fatty acid is also appropriately adjusted similarly to the amine compound. The specific attached amount of the fatty acid or the hydroxy fatty acid is not particularly limited, but is preferably 1.5 mass% or less and more preferably 1.3 mass% or less, and preferably 0.01 mass% or more with respect to 100 mass% of the mass of the silver particles A. The content of the fatty acid and the hydroxy fatty acid attached to the silver particles A can be measured by differential thermal analysis.

As long as the silver particles A of the present invention satisfy the above average particle size, the amine compound, the fatty acid, and the hydroxy fatty acid may be used in combination, or another compound different from these may be attached to the surfaces of the silver particles. It is particularly preferable that the amine compound is attached to the surfaces of the silver particles A of the present invention.


Silver Particles B


The silver particles B of the present invention are in a range of 40 nm to 500 nm. The average particle size of the silver particles B may be in a range of 40 nm to 500 nm, but from the viewpoint of more suitably exhibiting the effects of the present invention, the lower limit is preferably 50 nm or more and more preferably 60 nm or more, the upper limit is preferably 300 nm or less, more preferably 250 nm or less, and further preferably 200 nm or less, and the preferred range is 40 to 300 nm, 40 to 250 nm, 40 to 200 nm, 50 to 300 nm, 50 to 250 nm, 50 to 200 nm, 60 to 300 nm, 60 to 250 nm, 60 to 200 nm, or the like.

In the present invention, the average particle size of the silver particles B is a volume-based average particle size measured for 200 randomly selected particles in an SEM image using image analysis software (for example, Macview (manufactured by Mountech Co., Ltd.)). For the SEM observation, a range with a lateral width of 1 to 20 $\mu$m is observed at an observation magnification of 5000 to 30000 at an acceleration voltage of 20 kV using an SED mode (secondary electron detector). The longitudinal direction of the SEM image is a width in which 200 or more (usually, about 200 to 300) silver particles are included in a range with a lateral width of 1 to 20 μm. The volume-based average particle size is a value measured assuming that the particles observed in the SEM image are spherical particles having the diameters of the observed particles. A specific measurement method is as described in Examples.

A dry powder of the silver particles B of the present invention has a weight reduction rate of preferably 1.5 wt% or less and more preferably 0.05 to 1.3 wt% at the time of heating from 30°C to 500°C by thermogravimetric differential thermal analysis. The method of thermogravimetric differential thermal analysis is as follows.

<Thermogravimetric Differential Thermal Analysis (TG-DTA)>

First, air dried silver particles B are prepared. For example, when silver particles B are obtained from the electroconductive adhesive and analyzed, 2 g of methanol is added to 1 g of each electroconductive adhesive and sufficiently dispersed, the silver particles B are then collected by filtration and air-dried to obtain a silver particle dry powder, and the silver particle dry powder is used as an analysis target. TG-DTA of the dry powder of the silver particles B is measured with a thermogravimetric differential thermal analyzer (for example, HITACHI G300 AST-2). The measurement conditions are as follows: atmosphere: air, measurement temperature: 30 to 500°C, and temperature increase rate: 10°C/min. From the obtained TG-DTA chart, an exothermic peak attributable to binding of the silver particles B in TG-DTA analysis and a weight reduction rate at the time of heating from 30°C to 500°C by thermal analysis are obtained.

From the viewpoint of more suitably exhibiting the effects of the present invention, the silver particles B are preferably surface-treated. That is, the silver particles B of the present invention are preferably surface-treated silver particles.

More specifically, it is preferable that an amine compound is attached to the surfaces of the silver particles B of the present invention. The amine compound is attached to the surfaces of the silver particles B and can form a protective layer. In the silver particles B of the present invention, it is preferable to attach the amine compound so that the average particle size is set in the above specific range.

The amine compound is not particularly limited and can include a primary amine, a secondary amine, a tertiary amine, and a diamine compound having two amino groups in one compound, from the viewpoint of more suitably exhibiting the effects of the present invention.

Examples of the primary amine include amines having a straight or branched hydrocarbon group such as ethylamine, n-propylamine, isopropylamine, 1,2-dimethylpropylamine, n-butylamine, isobutylamine, sec-butylamine, tert-butylamine, isoamylamine, n-octylamine, 2-octylamine, tert-octylamine, 2-ethylhexylamine, n-nonylamine, n-aminodecane, n-aminoundecane, n-dodecylamine, n-tridecylamine, 2-tridecylamine, n-tetradecylamine, n-pentadecylamine, n-hexadecylamine, n-heptadecylamine, n-octadecylamine, n-oleylamine, 3-methoxypropylamine, 3-ethoxypropylamine, 3-propoxypropylamine, 3-isopropoxypropylamine, 3-butoxypropylamine, N-ethyl-1,3-diaminopropane, N,N-diisopropylethylamine, N,N-dimethyl-1,3-diaminopropane, N,N-dibutyl-1,3-aminopropane, N,N-diisobutyl-1,3-diaminopropane, and N-lauryl diaminopropane.

Examples of the primary amine also include alicyclic amines such as cyclopropylamine, cyclobutylamine, cyclopropylamine, cyclohexylamine, cycloheptylamine, and cyclooctylamine, and aromatic amines such as aniline.

Examples of the primary amine also include ether amines such as 3-isopropoxypropylamine and isobutoxypropylamine.

Examples of the secondary amine include dialkylmonoamines such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, N,N-distearylamine, N-methyl-N-propylamine, N-ethyl-N-propylamine, and N-propyl-N-butylamine, and cyclic amines such as piperidine.

Examples of the tertiary amine include triethylamine, tributylamine, trihexylamine, dimethyloctylamine, dimethyldecylamine, dimethyllaurylamine, dimethylmyristylamine, dimethylpalmitylamine, dimethylstearylamine, and dilaurylmonomethylamine.

As the amine, a diamine compound having two amino groups in one compound can also be used. Examples of the diamine compound include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-propanediamine, N,N'-dimethyl-1,3-propanediamine, N,N-diethyl-1,3-propanediamine, N,N'-diethyl-1,3-propanediamine, 1,4-butanediamine, N,N-dimethyl-1,4-butanediamine, N,N'-dimethyl-1,4-butanediamine, N,N-diethyl-1,4-butanediamine, N,N'-diethyl-1,4-butanediamine, 1,5-pentanediamine, 1,5-diamino-2-methylpentane, 1,6-hexanediamine, N,N-dimethyl-1,6-hexanediamine, N,N'-dimethyl-1,6-hexanediamine, 1,7-heptanediamine, and 1,8-octanediamine.

As the amine compound on the surfaces of the silver particles B of the present invention, n-propylamine, isopropylamine, cyclopropylamine, n-butylamine, isobutylamine, sec-butylamine, tert-butylamine, cyclobutylamine, n-amylamine, n-hexylamine, cyclohexylamine, n-octylamine, 2-ethylhexylamine, n-dodecylamine, n-oleylamine, 3-methoxypropylamine, 3-ethoxypropylamine, N,N-dimethyl-1,3-diaminopropane, and N,N-diethyl-1,3-diaminopropane are preferable, and n-butylamine, n-hexylamine, n-octylamine, 3-methoxypropylamine, n-dodecylamine, N,N-dimethyl-1,3-diaminopropane, and N,N-diethyl-1,3-diaminopropane are more preferable.

The attached amount of the amine compound of the silver particles B of the present invention is not particularly limited, but is preferably 1.5 mass% or less and more preferably 1.3 mass% or less with respect to 100 mass% of the mass of the silver particles, and the lower limit is preferably 0.05 mass% or more. The content of the amine compound attached to the silver particles B can be measured by thermogravimetric differential thermal analysis.

A fatty acid, a hydroxy fatty acid, or the like may be attached to the surfaces of the silver particles B. The fatty acid is not particularly limited, but is, for example, preferably a fatty acid having an alkyl group with 3 or more and 18 or less carbon atoms and more preferably a fatty acid having an alkyl group with 4 or more and 18 or less carbon atoms. Preferred specific examples of the fatty acid include acetic acid, propionic acid, butyric acid, valeric acid, caproic acid, caprylic acid, 2-ethylhexanoic acid, capric acid, lauric acid, myristic acid, palmitic acid, stearic acid, oleic acid, linoleic acid, and α-linolenic acid. Specific examples of the fatty acid also include cyclic alkyl carboxylic acids such as cyclohexanecarboxylic acid. As the hydroxy fatty acid, a compound having 3 to 24 carbon atoms and one or more (for example, one) hydroxyl groups can be used. Examples of the hydroxy fatty acid include 2-hydroxydecanoic acid, 2-hydroxydodecanoic acid, 2-hydroxytetradecanoic acid, 2-hydroxyhexadecanoic acid, 2-hydroxyoctadecanoic acid, 2-hydroxyeicosanoic acid, 2-hydroxydocosanoic acid, 2-hydroxytricosanoic acid, 2-hydroxytetracosanoic acid, 3-hydroxyhexanoic acid, 3-hydroxyoctanoic acid, 3-hydroxynonanoic acid, 3-hydroxydecanoic acid, 3-hydroxyundecanoic acid, 3-hydroxydodecanoic acid, 3-hydroxytridecanoic acid, 3-hydroxytetradecanoic acid, 3-hydroxyhexadecanoic acid, 3-hydroxyheptadecanoic acid, 3-hydroxyoctadecanoic acid, co-hydroxy-2-decenoic acid, ω-hydroxypentadecanoic acid, ω-hydroxyheptadecanoic acid, ω-hydroxyeicosanoic acid, ω-hydroxydocosanoic acid, 6-hydroxyoctadecanoic acid, ricinoleic acid, 12-hydroxystearic acid, and [R-(E)]-12-hydroxy-9-octadecenoic acid. Among them, a hydroxy fatty acid having 4 to 18 carbon atoms and one hydroxyl group at a position (particularly, the 12-position) other than the ω-position is preferable, and ricinoleic acid and 12-hydroxystearic acid are more preferable. Each of the fatty acid and the hydroxy fatty acid may be used singly or may be used in combination of two or more kinds thereof.

In the silver particles B of the present invention, the attached amount of the fatty acid or the hydroxy fatty acid is also appropriately adjusted similarly to the amine compound. The specific attached amount of the fatty acid or the hydroxy fatty acid is not particularly limited, but is preferably 1.5 mass% or less and more preferably 1.3 mass% or less, and preferably 0.01 mass% or more with respect to 100 mass% of the mass of the silver particles B. The content of the fatty acid and the hydroxy fatty acid attached to the silver particles B can be measured by differential thermal analysis.

As long as the silver particles B of the present invention satisfy the above average particle size, the amine compound, the fatty acid, and the hydroxy fatty acid may be used in combination, or another compound different from these may be attached to the surfaces of the silver particles. It is particularly preferable that the amine compound is attached to the surfaces of the silver particles B of the present invention.

Silver Particles C

The average particle size of the silver particles C may be in a range of 0.5 to 5.5 μm, but from the viewpoint of more suitably exhibiting the effects of the present invention, the lower limit is preferably 0.6 μm or more, the upper limit is preferably 3.0 μm or less, more preferably 2.5 μm or less, and further preferably 2.0 μm or less, and the preferred range is 0.5 to 3.0 μm, 0.5 to 2.5 μm, 0.5 to 2.0 μm, 0.6 to 3.0 μm, 0.6 to 2.5 μm, or 0.6 to 2.0 μm.

In the present invention, the average particle size of the silver particles C can be measured by a particle size distribution measuring device based on a laser diffraction/scattering method, or can be measured from an electron micrograph, and further can be calculated from the electron micrograph using an image processing apparatus.

As the silver particles C in the present invention, commercially available silver particles may be used, and silver particles synthesized by a known synthesis method may be used.

From the viewpoint of effectively enhancing the mechanical strength of the sintered body, in the electroconductive adhesive of the present invention, the mass ratio (A : B : C) of the silver particles A, the silver particles B, and the silver particles C may be about 1 to 20 : 30 to 60 : 40 to 70, and is preferably about 1 to 15 : 30 to 50 : 40 to 60.

Solvent

The solvent is not particularly limited as long as it allows the silver particles to be dispersed therein, but preferably includes a polar organic solvent. Examples of the polar organic solvent include ketones such as acetone, acetylacetone, and methyl ethyl ketone; ethers such as diethyl ether, dipropyl ether, dibutyl ether, tetrahydrofuran, and 1,4-dioxane; diols such as 1,2-propanediol, 1,2-butanediol, 1,3-butanediol, 1,4-butanediol, 2,3-butanediol, 1,2-hexanediol, 1,6-hexanediol, 1,2-pentanediol, 1,5-pentanediol, 2-methyl-2,4-pentanediol, 3-methyl-1,5-pentanediol, 1,2-octanediol, 1,8-octanediol, and 2-ethyl-1,3-hexanediol; glycerol; alcohols such as a straight or branched alcohol having 1 to 5 carbon atoms, cyclohexanol, 3-methoxy-3-methyl-1-butanol, and 3-methoxy-1-butanol; fatty acid esters such as ethyl acetate, butyl acetate, ethyl butyrate, ethyl formate, and texanol; glycols or glycol ethers such as polyethylene glycol, triethylene glycol monomethyl ether, tetraethylene glycol monomethyl ether, ethylene glycol monoethyl ether, diethylene glycol monoethyl ether, diethylene glycol dimethyl ether, triethylene glycol dimethyl ether, tetraethylene glycol dimethyl ether, 3-methoxybutyl acetate, ethylene glycol monobutyl ether, ethylene glycol monobutyl ether acetate, ethylene glycol monohexyl ether, ethylene glycol monooctyl ether, ethylene glycol mono-2-ethylhexyl ether, ethylene glycol monobenzyl ether, diethylene glycol monomethyl ether, diethylene glycol monomethyl ether acetate, diethylene glycol monoethyl ether, diethylene glycol monoethyl ether acetate, diethylene glycol monobutyl ether, diethylene glycol monobutyl ether acetate, diethylene glycol monhexyl ether, diethylene glycol mon-2-ethylhexyl ether, polypropylene glycol, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tripropylene glycol monoethyl ether, tripropylene glycol monopropyl ether, and tripropylene glycol monobutyl ether; N,N-dimethylformamide; dimethyl sulfoxide; terpenes such as terpineol; acetonitrile; $\gamma$-butyrolactone; 2-pyrrolidone; N-methylpyrrolidone; and N-(2-aminoethyl)piperazine. Among these, from the viewpoint of more suitably exhibiting the effects of the present invention, a straight or branched alcohol having 3 to 5 carbon atoms, 3-methoxy-3-methyl-1-butanol, 3-methoxy-1-butanol, diethylene glycol monobutyl ether, diethylene glycol monobutyl ether acetate, diethylene glycol monohexyl ether, diethylene glycol mono-2-ethylhexyl ether, terpineol, and texanol are preferable.

The solvent may include a non-polar or hydrophobic solvent in addition to the polar organic solvent. Examples of the non-polar organic solvent include straight, branched, or cyclic saturated hydrocarbons such as hexane, heptane, octane, nonane, decane, 2-ethylhexane, and cyclohexane; alcohols such as a straight or branched alcohol having 6 or more carbon atoms; aromatic compounds such as benzene, toluene, and benzonitrile; halogenated hydrocarbons such as dichloromethane, chloroform, and dichloroethane; methyl-n-amyl ketone; methyl ethyl ketone oxime; and triacetin. Among these, saturated hydrocarbon and a straight or branched alcohol having 6 or more carbon atoms are preferable, and hexane, octane, decane, octanol, decanol, and dodecanol are more preferable. The solvent can be used singly or as a mixture of two or more kinds thereof.

When the solvent includes both a polar organic solvent and a non-polar organic solvent, the proportion of the polar organic solvent is preferably 5 vol% or more, more preferably 10 vol% or more, and still more preferably 15 vol% or more, with respect to the total amount of the solvent. The proportion of the polar organic solvent can be set to 60 vol% or less, can also be set to 55 vol% or less, or can also be set to 50 vol% or less. The solvent can also be composed of only a polar organic solvent. The electroconductive adhesive of the present invention has good dispersibility of the silver particles also when containing a large amount of a polar organic solvent as described above.

In the electroconductive adhesive of the present invention, the ratio of the solvent is not particularly limited, but is preferably 20 mass% or less and more preferably about 5 mass% to 15 mass%.

The content of the silver particles (total of the silver particles A, the silver particles B, and the silver particles C) contained in the electroconductive adhesive of the present invention is preferably 80 mass% or more and more preferably 85 mass% or more.

The electroconductive adhesive of the present invention can be produced by a method including a step of mixing respective silver particles with a solvent.

In a method for producing an electroconductive adhesive of the present invention, the silver particles of the present invention produced in a solvent in a method for producing silver particles of the present invention described below may be used together with the solvent to form the electroconductive adhesive of the present invention.

In the electroconductive adhesive of the present invention, the shear strength of a sintered body obtained by heating the electroconductive adhesive at 200°C is preferably 73 MPa or more, more preferably 77 MPa or more, and further preferably 80 MPa or more. The upper limit of the shear strength is, for example, 200 MPa or less. The shear strength of a sintered body obtained by heating the electroconductive adhesive of the present invention at 250°C is preferably 70 MPa or more, more preferably 72 MPa or more, and further preferably 75 MPa or more. The upper limit of the shear strength is, for example, 200 MPa or less. The method for measuring the shear strength of the sintered body is as follows, and specifically, the shear strength is measured by the method described in Examples.

<Shear Strength>

First, a substrate with non-electrolytic silver plating of 0.5 $\mu$m on a copper plate is prepared. An electroconductive adhesive (silver particle dispersion of 90 mass% of silver particles and 10 mass% of a solvent (for example, texanol or the like)) is uniformly applied onto the substrate (surface on which silver plating is formed) to form a coating film such that the thickness of the coating film reaches 50 to 100 $\mu$m (adjusted by the thickness of the joined body after sintering). A silicon wafer (size 2 mm × 2 mm) having a rear surface (surface in contact with the electroconductive adhesive) thereof subjected to gold plating is laminated on the coating film to obtain a laminate. Next, the obtained laminate is heated using a drier (circulation type) under sintering conditions of a predetermined sintering temperature (200°C or 250°C) and 60 minutes, and each electroconductive adhesive between the substrate and the silicon wafer is sintered to nine laminates in which the substrate and the silicon wafer are joined with the sintered body interposed therebetween. The thickness of the joined body is 30 to 90 μm, and the film thicknesses of the electroconductive adhesives to be compared are aligned and compared. For each of the obtained laminates, a load is applied to the sintered body under the condition of 0.120 mm/s at room temperature using a bond tester (for example, SS30-WD manufactured by SEISHIN TRADING CO., LTD.), and a die shear test of each laminate is performed to measure the maximum load at break. The maximum load thus obtained is divided by the joining area to obtain a shear strength value. The measurement result is an average value of nine gold-plated silicon wafers whose shear strength has been measured. The sintering time at a predetermined sintering temperature may be 60 minutes or longer, and pre-firing may be performed at 50 to 100°C for 2 hours or shorter before main sintering at a predetermined sintering temperature.

In the electroconductive adhesive of the present invention, the denseness of a sintered body obtained by heating the electroconductive adhesive at 200°C is preferably 80% or more and more preferably 85% or more. The upper limit of the denseness is, for example, 95% or less. The denseness of a sintered body obtained by heating the electroconductive adhesive of the present invention at 250°C is preferably 83% or more and more preferably 85% or more. The upper limit of the denseness is, for example, 97% or less. The method for measuring the denseness of the sintered body is as follows, and specifically, the shear strength is measured by the method described in Examples.

<Denseness>

In the same method as in the method described in the section of <Shear Strength>, a laminate in which a substrate and a silicon wafer are joined with a sintered body interposed therebetween is obtained. Next, the sintered body is embedded in a resin together with the laminate with an epoxy resin (for example, manufactured by Bühler), and left to stand still for 24 hours to cure the resin. The resin-embedded laminate is cut with a precision low-speed cutting machine (for example, TechCut4 manufactured by ALLIED HIGH TECH PRODUCTS, INC.), and cross-section milling is performed by an ion milling (for example, manufactured by Hitachi High-Technologies Corporation) (for example, IM4000PLUS manufactured by Hitachi High-Technologies Corporation). The cross-section milling is performed by irradiating ion beams with a swing of $\pm30°$ at an argon gas flow rate of 0.07 cm$^3$/min and at a discharge voltage of 1.5 kV and an acceleration voltage of 6 kV. The cross-section of the sintered body obtained by the cross-section milling is observed with a scanning electron microscope to acquire an SEM image. For the SEM observation, a range with a lateral width of 60 μm is observed in a field of view at a magnification of 2000 at an acceleration voltage of 20 kV using an SED mode (secondary electron detector). For the longitudinal direction of the SEM image, the vertical width of the sintered layer of silver is in a range of 30 μm or more and 200 μm or less. This is because when the thickness of the sintered layer of silver is less than 10 μm, mechanical strength may be impaired due to characteristics as a joined body, and when the thickness thereof is more than 200 μm, since the volume of the laminate is increased, it is assumed that outgassing during sintering hardly occurs uniformly, which is disadvantageous from the viewpoint of reliability. This observation range is not limited to a 2 mm × 2 mm chip or the like, and even a chip having a size of 5 mm × 5 mm or more is set to the same observation range. When the nonuniformity of the sintered body structure is high, the range with a lateral width of 60 μm and a vertical width of 30 μm or more is observed plural times, and the average value thereof is taken as the denseness. The denseness is calculated by converting the obtained SEM image into two gradations of white and black by binarization software (Imagej) and determining the denseness by the following relational expression.

$$\text{Denseness (\%)} = \text{Sintered silver area (number of white pixels)} \div \text{Sintered body total area \{sintered silver area (number of white pixels)} + \text{Pore area (number of black pixels)\}} \times 100$$

<Specific Resistance Value>

An electroconductive adhesive (silver particle dispersion of 90 mass% of silver particles and 10 mass% of a solvent (for example, texanol)) is uniformly applied onto a polyimide film to form a coating film having a size of 2 mm × 60 mm × the coating film thickness of 50 μm, and fired at a predetermined temperature (200°C or 250°C) for 60 minutes to obtain a sintered body. Next, the resistance value of the sintered body is measured with a resistance meter (for example, HIOKI RM3548) under a room temperature condition, and the specific resistance (volume resistance) value is determined from the value obtained by measuring the actual film thickness with a micrometer. This specific resistance value is an average value of values obtained by measuring four portions of the sintered body.

In the electroconductive adhesive of the present invention, the specific resistance value of a sintered body obtained by heating the electroconductive adhesive at 200°C is preferably 3.5 $\mu\Omega\cdot$cm or less, more preferably 3.3 $\mu\Omega\cdot$cm or less, and further preferably 3.0 $\mu\Omega\cdot$cm or less. The lower limit of the specific resistance value is, for example, 2.0 $\mu\Omega\cdot$cm or more. The specific resistance value of a sintered body obtained by heating the electroconductive adhesive of the present invention at 250°C is preferably 3.2 $\mu\Omega\cdot$cm or less and more preferably 3.0 $\mu\Omega\cdot$cm or less. The lower limit of the specific resistance value is, for example, 1.8 $\mu\Omega\cdot$cm or more. The method for measuring the specific resistance value of the sintered body is as described in the above section of <Specific Resistance Value>, and specifically, the specific resistance value is measured by the method described in Examples.

<Void>

An SEM image of the sintered body is acquired in the same manner as in the measurement of <Denseness>, the SEM image binarized using Imagej is subjected to image processing (analysis of void portions in the binarized image as particles by automatic reading of color difference) using image analysis type particle size distribution measurement software (Macview) (manufactured by Mountech Co., Ltd.), voids of the sintered body are assumed to be spherical, and the number average size of the voids is calculated. At this time, the specific surface area of the sintered body is calculated from the surface area per unit volume of the spherical shape. The void portion is a pore portion generated by outgas or particle growth different from voids or cracks, and the pore portion has a diameter of 50 nm or more and 10 $\mu$m or less. Holes that are connected to each other with a diameter of more than 10 $\mu$m due to continuous voids are referred to as voids or cracks, and these holes are excluded from the void portions and converted. This was regarded as a value obtained by calculating the connected pores that appear when the cross-sectional SEM image is binarized as described above.

In the electroconductive adhesive of the present invention, voids of a sintered body obtained by heating the electroconductive adhesive at 200°C have, for example, the following features. The sintered body is formed by the method described in the section of <Shear strengths The number average size of the voids is, for example, 0.3 to 1.1 $\mu$m. The specific surface area of the void is, for example, 0.15 to 1.0 $\mu$m$^2$. The number average size was calculated by the image processing method using Macview.

2. Method for Producing Silver Particles

An example of the method for producing silver particles contained in the electroconductive adhesive of the present invention is described below.

First, a composition for producing silver particles (composition for preparing silver particles) is prepared. Specifically, a silver compound to be a raw material for silver particles, and as necessary, an amine compound or the like to be attached to the surfaces of the silver particles, and a solvent are prepared. From the viewpoint of more suitably exhibiting the effects of the present invention, examples of a preferred silver compound include silver nitrate and silver oxalate, and silver oxalate is particularly preferable. Examples of the solvent include the same solvents as those exemplified as the solvent to be blended in the electroconductive adhesive described below. Next, these respective components are mixed to obtain a composition for preparing silver particles. The proportion of each of the components in the composition is appropriately adjusted. For example, the content of silver oxalate in the composition is preferably set to about 20 to 70 mass% with respect to the total amount of the composition. When the amine compound is attached to the surfaces of the silver particles, the content of the amine compound is preferably about 5 mass% to 55 mass% with respect to the total amount of the composition. When the fatty acid is attached to the surfaces of the silver particles, the content of the fatty acid is preferably about 0.1 mass% to 20 mass% with respect to the total amount of the composition. When the hydroxy fatty acid is attached to the surfaces of the silver particles, the content of the hydroxy fatty acid is preferably about 0.1 mass% to 15 mass% with respect to the total amount of the composition.

It is also possible to synthesize silver particles once using a composition for preparing silver particles that has been adjusted such that the content of the amine compound or the like becomes outside the above range, and adjust the type and attached amount of the amine compound or the like to be the above physical properties (substitute the amine compound) by a method described below.

Means for mixing the respective components is not particularly limited, and it is possible to mix the respective components, for example, with a general-purpose device such as a mechanical stirrer, a magnetic stirrer, a vortex mixer, a planetary mill, a ball mill, a triple roll mill, a line mixer, a planetary mixer, or a dissolver. In order to avoid the silver particles from starting a thermal decomposition reaction by an increase in temperature of the composition due to an influence of, for example, heat of dissolution or heat of friction during mixing, it is preferable to mix the components while keeping the temperature of the composition at, for example, 60°C or lower, particularly, 40°C or lower.

Next, the composition for preparing silver particles is reacted in a reaction vessel, usually reacted by heating to cause a thermal decomposition reaction of the silver compound and thus generate silver particles. For the reaction, the composition may be introduced into the reaction vessel that has been heated in advance or the composition may be heated after introduced into the reaction vessel.

The reaction temperature may be any temperature that allows progress of the thermal decomposition reaction and generation of the silver particles, and is, for example, about 50 to 250°C. The reaction time may be appropriately selected according to the size of a desired average particle size and the constitution of the composition corresponding to the size of the desired average particle size. The reaction time is, for example, 1 minute to 100 hours.

Since the silver particles generated by the thermal decomposition reaction are obtained as a mixture containing an unreacted raw material, it is preferable to purify the silver particles. Examples of a purifying method include a solid-liquid separation method and a precipitation method of using a difference in specific gravity between silver particles and an unreacted raw material such as an organic solvent. Examples of the solid-liquid separation method include methods such as filter filtration, centrifugation, cyclone-type separation, and decantation. In order to facilitate handling of the mixture during purification, the mixture containing the silver particles may be diluted with a low-boiling-point solvent such as acetone or methanol to adjust the viscosity of the mixture.

It is possible to adjust the average particle size of silver particles to be obtained by adjusting the constitution of the composition for producing silver particles, and reaction conditions.

Method for Substituting and Adjusting Amine Compound on Silver Particle Surface

The silver particles (having an amine compound attached to surfaces thereof) once synthesized by the above method are prepared and dispersed in a solvent. Examples of the solvent include the same solvents as those exemplified as the solvent to be blended in the electroconductive adhesive described below. Next, another amine compound is added in an amount in a range of 0.1 to 5 times the mass of the silver particles, and the mixture is subjected to a step of stirring at room temperature to 80°C for 1 minute to 24 hours, whereby the type of the amine compound attached to the surfaces of the silver particles can be substituted or the attached amount thereof can be adjusted. The silver particles in which the amine compound is substituted can be recovered by the above-described solid-liquid separation method or the like.

3. Sintered Body of Electroconductive Adhesive

A sintered body of the electroconductive adhesive of the present invention is obtained by sintering the electroconductive adhesive of the present invention described above in detail in "1. Electroconductive Adhesive" above. In the sintered body of the electroconductive adhesive of the present invention, most of the component (such as the amine compound) attached to the surfaces of the silver particles and the solvent are separated by high heat during sintering, so that the sintered body is substantially formed of silver.

The sintering temperature is not particularly limited, but is, for example, 250°C or lower, preferably about 150°C to 250°C, and more preferably about 200°C to 250°C, from the viewpoint of increasing the shear strength and denseness of a sintered body to be obtained while suitably sintering at a low temperature. From the same viewpoint, the sintering time is preferably about 0.4 hours to 2.0 hours and more preferably about 0.5 hours to 1.5 hours. The sintering time refers to a main sintering time (for which a predetermined temperature is maintained after reaching the predetermined temperature), and in addition to this, preliminary baking (a step of mildly heating at a low temperature of 100°C or lower before reaching the predetermined temperature) may be performed. In the present invention, by satisfying that the electroconductive adhesive contains the silver particles A having an average particle size of less than 40 nm, the silver particles B having an average particle size in a range of 40 to 500 nm, and the silver particles C having an average particle size in a range of 0.5 to 5.5 $\mu$m, and the silver particles A, the silver particles B, and the silver particles C are in a specific ratio range, the electroconductive adhesive is suitably sintered at a low temperature of 250°C or lower even without pressurization during sintering to form a sintered body having high denseness and a high mechanical strength (shear strength). Therefore, it is not essential to pressurize the electroconductive adhesive of the present invention during sintering. That is, the electroconductive adhesive of the present invention can be suitably used for use applications in which the electroconductive adhesive is used without pressurization during sintering. The pressure may be applied at the time of sintering the electroconductive adhesive of the present invention, and the pressure in the case of pressurization is, for example, about 10 to 30 MPa. The sintering can be performed in an atmosphere of air, an inert gas (nitrogen gas or argon gas), or the like. Sintering means is not particularly limited, and examples thereof include an oven, a hot air drying furnace, an infrared drying furnace, laser irradiation, flash lamp irradiation, and a microwave.

The sintered body of the electroconductive adhesive of the present invention is obtained by uniformly applying the electroconductive adhesive onto a substrate and sintering the electroconductive adhesive at a predetermined temperature, but the film thickness at the time of applying the electroconductive adhesive to the substrate can be appropriately adjusted according to the purpose, and may be, for example, a thickness of about 10 to 100 $\mu$m. When a large (for example, about 10 mm × 10 mm) semiconductor chip is used, a semiconductor chip having a larger film thickness is preferred, and thus the film thickness when the electroconductive adhesive is applied to the substrate may be, for example, 30 μm or more, and is preferably 40 μm or more and more preferably 50 μm or more. The upper limit value of the film thickness in this case may be 200 μm or less, and is preferably 100 μm or less. By setting the film thickness as described above, even when a large semiconductor chip is used, a sufficient shear strength is obtained, and a sintered body in which cracking or chipping and voids or cracks are hardly generated is obtained.

The sintered body of the present invention preferably satisfies at least one of the shear strength, the denseness, and the specific resistance value described in the section of "1. Electroconductive Adhesive". Measurement methods of these are as described in the sections of <Shear Strength>, <Denseness>, and <Specific Resistance Value>.

4. Electronic Component

An electronic component of the present invention includes a portion where members are bonded by the sintered body of the present invention. That is, in the electronic component of the present invention, the electroconductive adhesive of the present invention described in detail in "1. Electroconductive Adhesive" above is disposed between members of the electronic component (for example, between members included in a circuit), and the electroconductive adhesive is sintered to bond the members to each other.

As described above, since the sintered body of the present invention has high denseness and a high shear strength, the electronic component including this sintered body also has a high shear strength between the members. The specific resistance value of the electronic component of the present invention can also be low.

EXAMPLES

The present invention will be more specifically described in the following Examples; however, the present invention is not limited thereto.

Details of each component used in Examples and Comparative Examples are as follows.

- Silver oxalate $((COOAg)_2)$ was synthesized by the method described in JP 5574761 B2.
- N,N-Dimethyl-1,3-diaminopropane (manufactured by FUJIFILM Wako Pure Chemical Corporation)
- N,N-Diethyl-1,3-diaminopropane (manufactured by FUJIFILM Wako Pure Chemical Corporation)
- n-Hexylamine (manufactured by FUJIFILM Wako Pure Chemical Corporation)
- n-Octylamine (manufactured by FUJIFILM Wako Pure Chemical Corporation)
- n-Dodecylamine (manufactured by FUJIFILM Wako Pure Chemical Corporation)
- Cyclohexylamine (manufactured by FUJIFILM Wako Pure Chemical Corporation)
- n-Butylamine (manufactured by FUJIFILM Wako Pure Chemical Corporation)
- Ricinoleic acid (manufactured by Tokyo Chemical Industry Co., Ltd.)
- Oleic acid (manufactured by Tokyo Chemical Industry Co., Ltd.)
- 1-Butanol (manufactured by FUJIFILM Wako Pure Chemical Corporation)
- Methanol (manufactured by FUJIFILM Wako Pure Chemical Corporation)
- Texanol (manufactured by FUJIFILM Wako Pure Chemical Corporation)

<Synthesis Example 1> Synthesis Example of Silver Particles A1 (Average Particle Size: 33 nm)

Oleic acid (0.06 g), n-octylamine (1.40 g), N,N-dimethyl-1,3-diaminopropane (0.43 g), n-dodecylamine (0.16 g), cyclohexylamine (0,12 g), and n-butylamine (0.64 g) were charged into 50-mL glass-made centrifuge tubes each having a magnetic stirrer placed therein, the mixture was stirred for about 1 hour, and then, silver oxalate (3.2 g) was charged into each of the centrifuge tubes and stirred for about 10 minutes to obtain a composition for preparing silver particles. Thereafter, these glass-made centrifuge tubes were set upright on a hot stirrer equipped with an aluminum block (HHE-19G-U manufactured by KOIKE PRECISION INSTRUMENTS), and the composition was stirred in a hot water bath at 40°C for 30 minutes and further stirred in an oil bath at 90°C for 30 minutes. After the composition was allowed to cool, the magnetic stirrer was taken out, 15 g of methanol was added to each composition and stirred with a vortex mixer, the composition was then subjected to a centrifugal operation for 1 minute at 3000 rpm (about 1600×G) by a centrifugal machine (CF7D2 manufactured by Hitachi Koki Co., Ltd.), and the centrifuge tube was inclined to remove a supernatant. The step of addition of 15 g of methanol, stirring, centrifugation, and removal of a supernatant was repeated two times, and silver particles A1 (average particle size: 33 nm) produced were recovered.

<Synthesis Example 2> Synthesis Example of Silver Particles B1 (Average Particle Size: 68 nm)

Ricinoleic acid (2.34 g), N,N-diethyl-1,3-diaminopropane (203 g), and 1-butanol (375 g) were charged into 50-mL glass-made centrifuge tubes each having a magnetic stirrer placed therein, the mixture was stirred for about 1 hour, and then, silver oxalate (250 g) was charged into each of the centrifuge tubes and stirred for about 10 minutes to obtain a composition for preparing silver particles B1. Thereafter, these glass-made centrifuge tubes were set upright on a hot stirrer equipped with an aluminum block (HHE-19G-U manufactured by KOIKE PRECISION INSTRUMENTS), and the composition was stirred at 40°C for 30 minutes and further stirred at 90°C for 30 minutes. After the composition was allowed to cool, the magnetic stirrer was taken out, 15 g of methanol was added to each composition and stirred with a vortex mixer, the composition was then subjected to a centrifugal operation for 1 minute at 3000 rpm (about 1600×G) by a centrifugal machine (CF7D2 manufactured by Hitachi Koki Co., Ltd.), and the centrifuge tube was inclined to remove a supernatant. The step of addition of 15 g of methanol, stirring, centrifugation, and removal of a supernatant was repeated two times, and silver particles were recovered.

Next, using a dispersion (methanol solution) of the obtained silver particles, n-hexylamine was added in an amount of 3 times the mass of the silver particles and the mixture was stirred at room temperature for 4 hours. After the stirring, the magnetic stirrer was taken out, 15 g of methanol was added to each composition and stirred with a vortex mixer, the composition was then subjected to a centrifugal operation for 1 minute at 3000 rpm (about 1600×G) by a centrifugal machine (CF7D2 manufactured by Hitachi Koki Co., Ltd.), and the centrifuge tube was inclined to remove a supernatant. The step of addition of 15 g of methanol, stirring, centrifugation, and removal of a supernatant was repeated two times, and silver particles B1 (average particle size: 68 nm) in which the protective layer attached to the surfaces of the silver particles was substituted with n-hexylamine were recovered.

<Synthesis Example 3> Synthesis Example of Silver Particles B2 (Average Particle Size: 181 nm)

Ricinoleic acid (6.25 g), N,N-diethyl-1,3-diaminopropane (203 g), and 1-butanol (187.5 g) were charged into 50-mL glass-made centrifuge tubes each having a magnetic stirrer placed therein, the mixture was stirred for about 1 hour, and then, silver oxalate (250 g) was charged into each of the centrifuge tubes and stirred for about 10 minutes to obtain a composition for preparing silver particles B2. Thereafter, these glass-made centrifuge tubes were set upright on a hot stirrer equipped with an aluminum block (HHE-19G-U manufactured by KOIKE PRECISION INSTRUMENTS), and the composition was stirred at 40°C for 30 minutes and further stirred at 90°C for 30 minutes. After the composition was allowed to cool, the magnetic stirrer was taken out, 15 g of methanol was added to each composition and stirred with a vortex mixer, the composition was then subjected to a centrifugal operation for 1 minute at 3000 rpm (about 1600×G) by a centrifugal machine (CF7D2 manufactured by Hitachi Koki Co., Ltd.), and the centrifuge tube was inclined to remove a supernatant. The step of addition of 15 g of methanol, stirring, centrifugation, and removal of a supernatant was repeated two times, and silver particles were recovered.

Next, using a dispersion (methanol solution) of the obtained silver particles, n-hexylamine was added in an amount of 3 times the mass of the silver particles and the mixture was stirred at room temperature for 4 hours. After the stirring, the magnetic stirrer was taken out, 15 g of methanol was added to each composition and stirred with a vortex mixer, the composition was then subjected to a centrifugal operation for 1 minute at 3000 rpm (about 1600×G) by a centrifugal machine (CF7D2 manufactured by Hitachi Koki Co., Ltd.), and the centrifuge tube was inclined to remove a supernatant. The step of addition of 15 g of methanol, stirring, centrifugation, and removal of a supernatant was repeated two times, and silver particles B2 (average particle size: 181 nm) in which the protective layer was substituted with n-hexylamine were recovered.

<Silver Particles C>

- As silver particles C1 (average particle size: 0.65 $\mu$m), product name AG2-1C manufactured by DOWA Electronics Materials Co., Ltd. was used.
- As silver particles C2 (average particle size: 1.88 $\mu$m), product name AG3-1F manufactured by DOWA Electronics Materials Co., Ltd. was used.

For each of the silver particles A1, B1, B2, C1, and C2, observation (acquisition of an SEM image) with a scanning electron microscope and measurement of an average particle size (volume-based average particle size) were performed under the following conditions. The results are shown in Table 1.

<Observation with Electron Microscope>

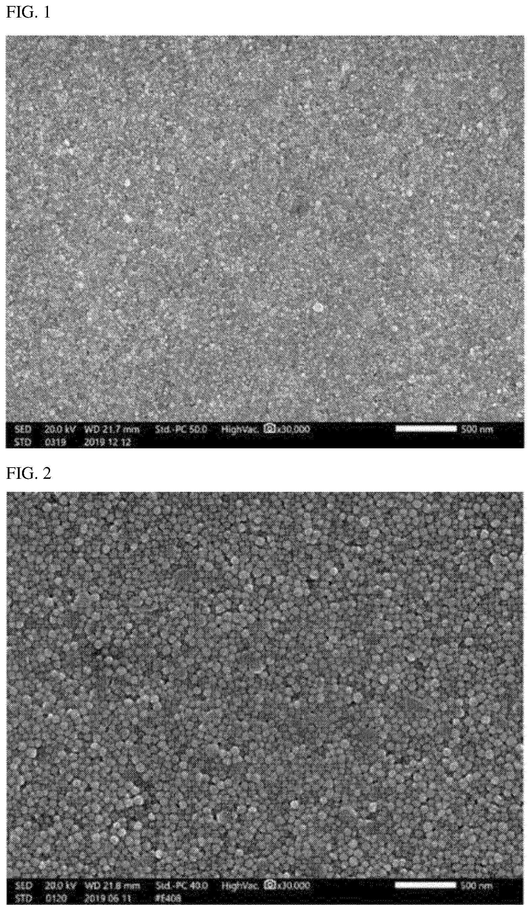

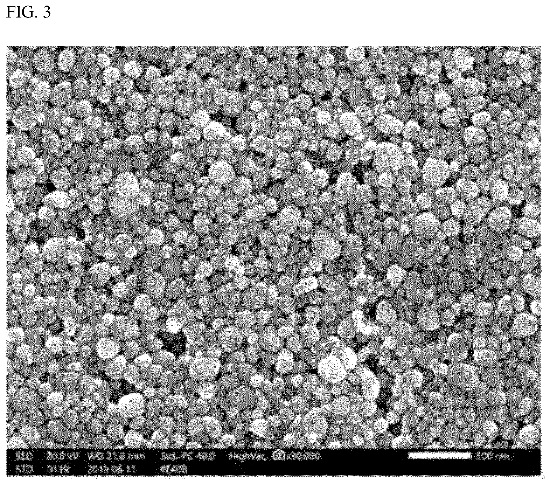

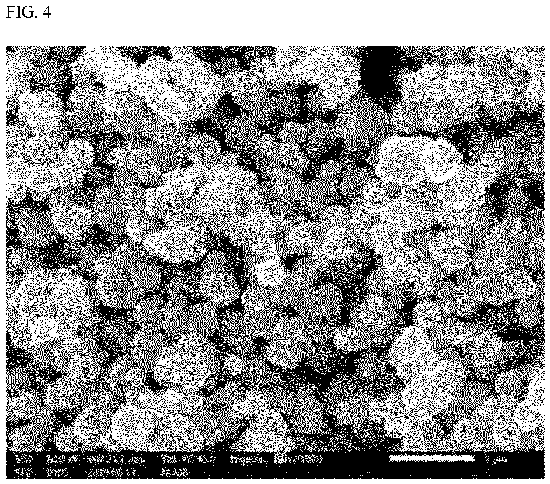

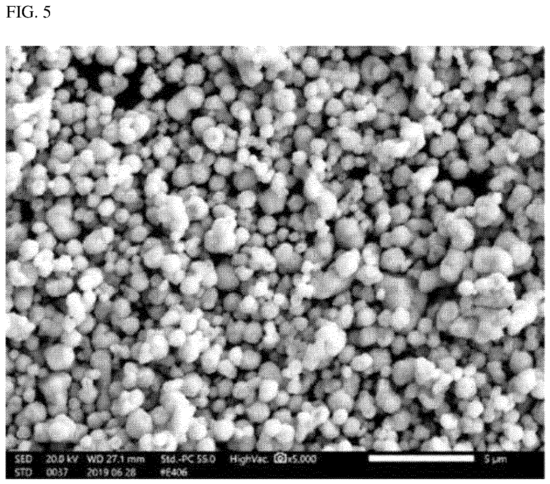

For each of the silver particles A1, B1, B2, C1, and C2, an SEM image was acquired using a scanning electron microscope (SEM (JSM-IT500HR manufactured by JEOL Ltd.)). Fig. 1 shows an SEM image of the silver particles A1, Fig. 2 shows an SEM image of the silver particles B1, Fig. 3 shows an SEM image of the silver particles B2, Fig. 4 shows an SEM image of the silver particles C1, and Fig. 5 shows an SEM image of the silver particles C2.

<Thermogravimetric Differential Thermal Analysis (TG-DTA measurement)>

The silver particles A1, the silver particles B1, and the silver particles B2 were measured using TG-DTA. Specifically, first, a solvent (texanol) was mixed with each of the silver particles A1, the silver particles B1, and the silver particles B2 in the same manner as in <Production of Electroconductive Adhesive> described below to prepare each silver particle dispersion having a concentration of 90 mass%. Next, 2 g of methanol was added to 1 g of each silver particle dispersion and thoroughly dispersed, and then the silver particles were collected by filtration and air-dried to obtain a silver particle dry powder. TG-DTA of the obtained silver particle dry powder was measured with HITACHI G300 AST-2. The measurement conditions were as follows: atmosphere: air, measurement temperature: 30 to 500°C, and temperature increase rate: 10°C/min. From the obtained TG-DTA chart, the weight reduction rate at the time of heating from 30°C to 500°C by thermal analysis was obtained. The results are shown in Table 1.

[Table 1]

| | | Silver particles A | Silver particles B1 | Silver particles B2 | Silver particles C1 | Silver particles C2 |
|---|---|---|---|---|---|---|
| Volume-based average particle size | | 33 nm | 68 nm | 181 nm | 0.65 $\mu$m | 1.88 $\mu$m |
| TG weight reduction rate (mass%) | Silver particle dispersion | 10 | 10 | 10 | - | - |
| | Dry powder | 1.4 | 1.1 | 0.6 | - | - |

<Production of Electroconductive Adhesive>

The silver particles A1, the silver particles B1, the silver particles B2, the silver particles C1, the silver particles C2, and a solvent (texanol) were mixed so as to have the compositions shown in Tables 2, 3, and 4, thereby preparing electroconductive adhesives. Specifically, first, texanol corresponding to 10 mass% was added to each of the silver particles A1, the silver particles B1, the silver particles B2, the silver particles C1, and the silver particles C2 to prepare each silver particle dispersion (a silver particle dispersion A1, a silver particle dispersion B1, a silver particle dispersion B2, a silver particle dispersion C1, and a silver particle dispersion C2, respectively) having a concentration of 90 mass%. For mixing, MAZERUSTAR manufactured by KURABO INDUSTRIES LTD. was used, and mixing was performed with a two-time stirring priority mode. Next, the respective silver particle dispersions and texanol were mixed so as to have the compositions shown in Table 2, thereby obtaining respective electroconductive adhesives including the compositions of Examples 1 to 6 and Comparative Examples 1 to 8.

[Table 2]

| Composition of electroconductive adhesive | | Comparative Example 1 | Example 1 | Example 2 | Example 3 | Comparative Example 2 |
|---|---|---|---|---|---|---|
| Silver particles A | Silver particles A (33 nm) | | 5 | 10 | 15 | 25 |
| Silver particles B | Silver particles B1 (68 nm) | 50 | 45 | 40 | 35 | 25 |
| Silver particles C | Silver particles C1 (0.65 $\mu$m) | 50 | 50 | 50 | 50 | 50 |

(continued)

| Composition of electroconductive adhesive | Comparative Example 1 | Example 1 | Example 2 | Example 3 | Comparative Example 2 |
|---|---|---|---|---|---|
| Solvent | 10 | 10 | 10 | 10 | 10 |
| The unit of the numerical value described for the silver particles A, the silver particles B, the silver particles C, and the solvent in Table 2 is part(s) by mass. | | | | | |

[Table 3]

| Composition of electroconductive adhesive | | Comparative Example 3 | Example 4 | Example 5 | Example 6 | Comparative Example 4 |
|---|---|---|---|---|---|---|
| Silver particles A | Silver particles A (33 nm) | | 5 | 10 | 10 | 25 |
| Silver particles B | Silver particles B2 (181 nm) | 50 | 45 | 40 | 40 | 25 |
| Silver particles C | Silver particles C 1 (0.65 $\mu$m) | | | | 50 | |
| | Silver particles C2 (1,88 $\mu$m) | 50 | 50 | 50 | | 50 |
| Solvent | | 10 | 10 | 10 | 10 | 10 |
| The unit of the numerical value described for the silver particles A, the silver particles B, the silver particles C, and the solvent in Table 3 is part(s) by mass. | | | | | | |

[Table 4]

| Composition of electroconductive adhesive | | Comparative Example 5 | Comparative Example 6 | Comparative Example 7 | Comparative Example 8 |
|---|---|---|---|---|---|
| Silver particles A | Silver particles A (33 nm) | 50 | 50 | 50 | 50 |
| Silver particles B | Silver particles B 1 (68 nm) | 50 | | | |
| | Silver particles B2 (181 nm) | | 50 | | |
| Silver particles C | Silver particles C 1 (0.65 $\mu$m) | | | 50 | |
| | Silver particles C2 (1,88 $\mu$m) | | | | 50 |
| Solvent | | 10 | 10 | 10 | 10 |
| The unit of the numerical value described for the silver particles A, the silver particles B, the silver particles C, and the solvent in Table 4 is part(s) by mass. | | | | | |

<Production of Sintered Body (Sintering Temperature 200°C)>

First, a substrate with non-electrolytic silver plating of 0.5 $\mu$m on a copper plate was prepared. An electroconductive adhesive (silver particle dispersion of 90 mass% of silver particles and 10 mass% of texanol) was uniformly applied onto the substrate (surface on which silver plating was formed) to form a coating film such that the thickness of the coating film reached 50 to 100 $\mu$m. A silicon wafer (size 2 mm × 2 mm) having a rear surface (surface in contact with the electroconductive adhesive) thereof subjected to gold plating was laminated on the coating film to obtain a laminate. Next, the obtained laminate was heated using a drier (circulation type) under sintering conditions of a predetermined sintering temperature (200°C) and 60 minutes, and each electroconductive adhesive between the substrate and the silicon wafer was sintered to nine laminates in which the substrate and the silicon wafer were joined with the sintered body interposed therebetween. The sintered body was prepared so as to have a thickness after sintering of 30 $\mu$m to 90 $\mu$m.

Various physical properties of each sintered body obtained from the electroconductive adhesives of Examples 1 to 6 and Comparative Examples 1 to 8 were measured under the following measurement conditions.

<Mechanical Strength (Shear Strength) of Sintered Body>

For each of the obtained laminates, a load was applied to the sintered body under the condition of 0.120 mm/s at room temperature using a bond tester (SS30-WD manufactured by SEISHIN TRADING CO., LTD.), and a die shear test of each laminate was performed to measure the maximum load at break. The maximum load thus obtained was divided by the joining area to obtain a shear strength value. The measurement result is an average value of nine gold-plated silicon wafers whose shear strength has been measured. The measurement results of the shear strength are shown in Tables 5, 6, and 7.

<Denseness of Sintered Body>

Each sintered body was embedded in a resin together with the laminate with an epoxy resin (manufactured by Bühler), and left to stand still for 24 hours to cure the resin. Next, the resin-embedded sintered body was cut with a precision low-speed cutting machine TechCut4 (manufactured by ALLIED HIGH TECH PRODUCTS, INC.), and cross-section milling was performed for 3 hours by an ion milling (IM4000PLUS) (manufactured by Hitachi High-Technologies Corporation). The cross-section milling was performed by irradiating ion beams with a swing of $\pm30°$ at an argon gas flow rate of 0.07 cm$^3$/min and at a discharge voltage of 1.5 kV and an acceleration voltage of 6 kV. The cross-section of the sintered body obtained by the cross-section milling was observed with a scanning electron microscope JSM-IT500HR (manufactured by JEOL Ltd.) to acquire an SEM image. For the observation, a range with a lateral width of 60 $\mu$m was observed in a field of view at a magnification of 2000 at an acceleration voltage of 20 kV using an SED mode (secondary electron detector). The denseness was calculated by converting the obtained SEM image into two gradations of white and black by binarization software "Image J" and determining the denseness by the following relational expression. The measurement results of the denseness are shown in Tables 5 and 6.

$$\text{Denseness (\%)} = \text{Sintered silver area (number of white pixels)} \div \text{Sintered body total area } \{\text{sintered silver area (number of white pixels)} + \text{Pore area (number of black pixels)}\} \times 100$$

<Specific Resistance Value of Sintered Body>

An electroconductive adhesive (silver particle dispersion of 90 mass% of silver particles and 10 mass% of texanol) was uniformly applied onto a polyimide film to form a coating film having a size of 2 mm $\times$ 60 mm $\times$ the coating film thickness of 50 $\mu$m, and fired at a predetermined temperature (200°C or 250°C) for 60 minutes to obtain a sintered body. Next, the resistance value of the sintered body was measured by a two-terminal measuring method using a resistance meter (HIOKI RM3548) under a room temperature condition, and the specific resistance (volume resistance) value was determined from the value obtained by measuring the actual film thickness with a micrometer. This specific resistance value is an average value of values obtained by measuring four portions of the sintered body. The measurement results of the specific resistance value are shown in Tables 5, 6, and 7.

<Film Defect>

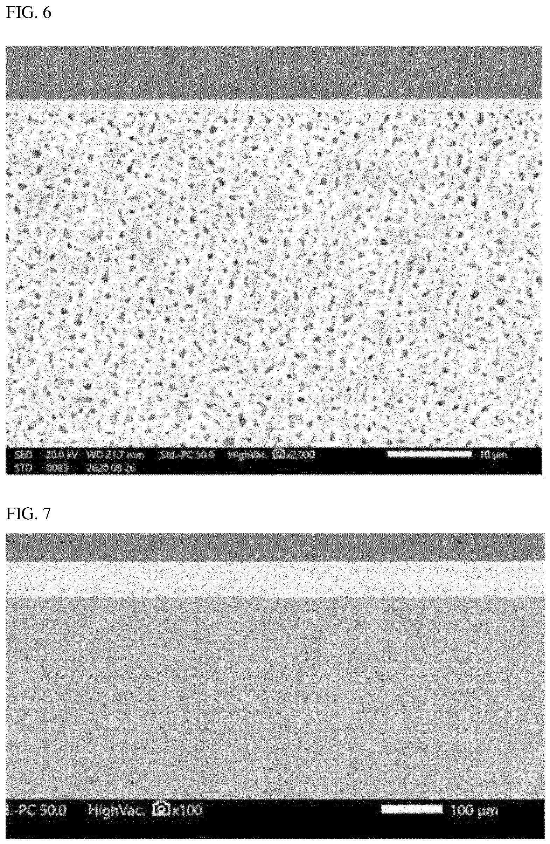

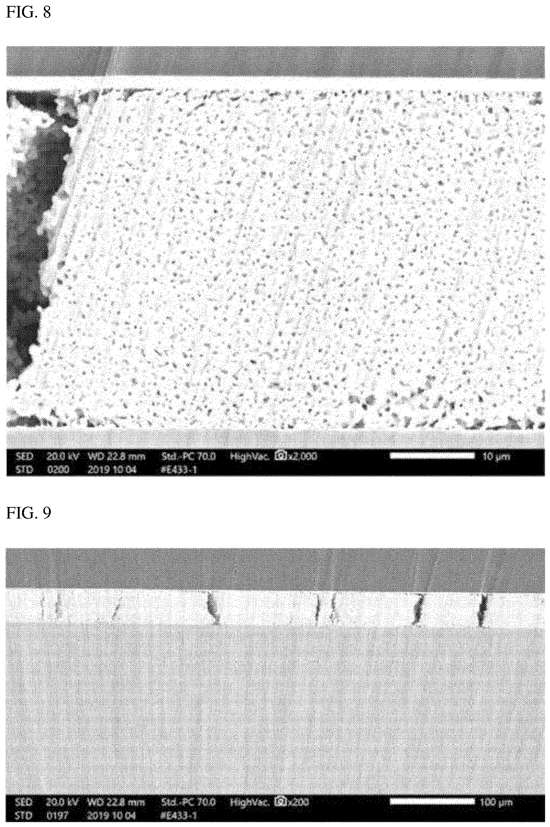

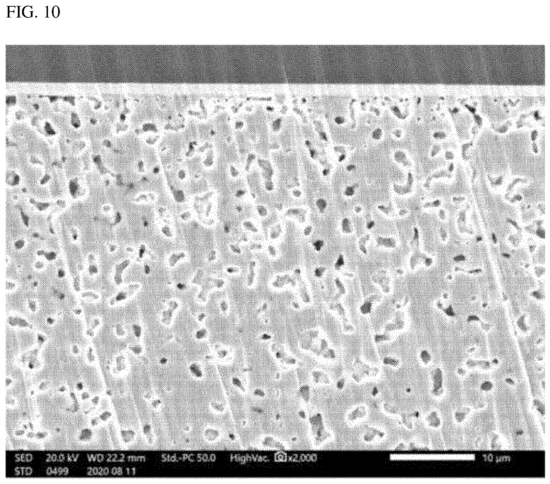

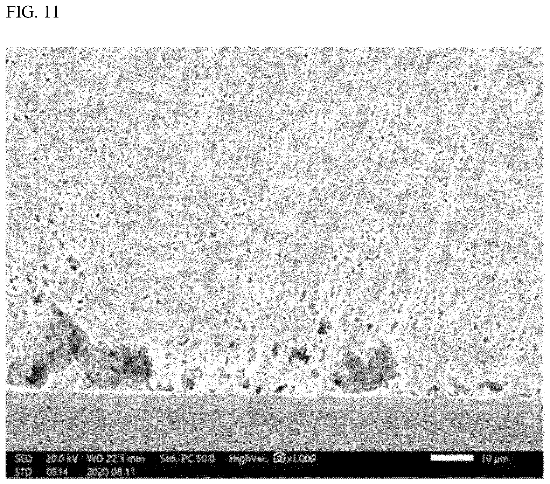

Each of the obtained sintered bodies was observed with an SEM in the same manner as in 0106 and then subjected to image processing to obtain a binarized image of the silver sintered body. In this binarized image, a sintered body in which at least one pore (black pixel) having a diameter of more than 10 $\mu$m existed was evaluated as $\times$, and a sintered body in which a pore (black pixel) having a diameter of more than 10 $\mu$m did not exist was evaluated as O. In order not to miss a defective portion, observation was performed at three or more places in a range of SEM magnification capable of securing a field of view having a lateral width of about 300 $\mu$m including a rectangular joining layer. In the cross-sectional SEM image, a wide range was observed, and a case including a sintered body in which apparent coarse voids having a diameter of several tens of $\mu$m were present even if binarization was not performed, or a silver sintered body which was determined to be unfused in which a contact point was not obtained exceeding 10 $\mu$m at a chip interface and a lead frame interface was also evaluated as $\times$. The wide range of the cross-sectional SEM image when the film defect is determined is a range of a lateral width of 1 mm or more and 5 mm or less. The results of presence or absence of the film defect are shown in Tables 5, 6, and 7. For the obtained sintered bodies, Figs. 6 and 7 show cross-sectional SEM photographs of the sintered body of Example 2, Figs. 8 and 9 show cross-sectional SEM photographs of the sintered body of Comparative Example 2, Fig. 10 shows a cross-sectional SEM photograph of the sintered body of Example 5, and Fig. 11 shows a cross-sectional SEM photograph of the sintered body of Comparative Example.

[Table 5]

| | Sintered body (sintering temperature 200°C) | | | |
|---|---|---|---|---|
| | Shear strength (MPa) | Denseness (%) | Specific resistance value ($\mu\Omega\cdot$cm) | Film defect |
| Comparative Example 1 | 85 | 85 | 2.75 | $\times$ |
| Example 1 | 87 | 81 | 3.02 | $\bigcirc$ |
| Example 2 | 90 | 95 | 2.81 | $\bigcirc$ |
| Example 3 | 89 | 87 | 3.04 | $\bigcirc$ |
| Comparative Example 2 | 83 | 56 | 3.9 | $\times$ |

As shown in Table 5, in Comparative Example 1 not containing the silver particles A, the basic denseness and the shear strength were good, but the initial filling structure was not dense, so that an action of filling the non-dense volume portion by sintering silver occurred, and as a result, defects such as stress cracking occurred. When such shrinkage failure occurs, it is disadvantageous for a heat resistance test such as a reliability test using the shrinkage failure as a starting point. On the other hand, in Examples 1, 2, and 3, the denseness was higher than that in Comparative Example 1, and a very dense structure was formed. The shear strength and the specific resistance value also showed good values, and particularly, Example 2 containing 10 wt% of the silver particles A showed excellent values. An SEM image of Example 2 at a magnification of 2000 was shown in Fig. 6. No defect occurs even when the film has a thickness of 50 $\mu$m or more, and it is estimated that these examples are advantageous in terms of reliability. As can be confirmed even in the wide observation range shown in Fig. 7, it is found that a uniform dense film can be formed in the composition of the present invention regardless of a thick film. On the other hand, Fig. 8 shows an SEM image of Comparative Example 2 in which the silver particles A were excessively added at a magnification of 2000, and although a part of the SEM image had very high denseness, defects were generated in the vicinity of the interface, and cracks due to shrinkage stress were present. A wider range of observation is shown in Fig. 9, but there were many defective portions over the entire surface. Although the coating thickness was the same as those of the other samples, the thickness of the sintered body was about 35 $\mu$m, and it was suggested that the shrinkage action was severe. It has been found that when a large amount of very fine and highly sinterable particles as the silver particles A are contained, defects due to high sintering action occur, and it has been proved that there is an optimum value when combining a plurality of silver particles as the silver particles A, B, and C.

[Table 6]

| | Sintered body (sintering temperature 200°C) | | | |
|---|---|---|---|---|
| | Shear strength (MPa) | Denseness (%) | Specific resistance value ($\mu\Omega\cdot$cm) | Film defect |
| Comparative Example 3 | 77 | 91 | 2.98 | $\times$ |
| Example 4 | 74 | 91 | 2.98 | $\bigcirc$ |
| Example 5 | 78 | 93 | 3.11 | $\bigcirc$ |
| Example 6 | 80 | 91 | 2.80 | $\bigcirc$ |
| Comparative Example 4 | 70 | 94 | 3.26 | $\times$ |

As shown in Table 6, it was found that in Comparative Example 3 not containing the silver particles A, the basic denseness, the strength, and the like were good, but the initial filling structure was not dense, so that an action of filling the non-dense volume portion by sintering silver occurred. On the other hand, it was found that in Examples 4, 5, and 6, there was no defect due to shrinkage, and a good film having a denseness of more than 91% was formed. In general, particles alone referred to as microsilver do not have high sinterability, and thus shrinkage is small, and film defects hardly occur. However, it is considered that the denseness is not increased accordingly, and the heat resistance is poor. It was proved that the silver particles in the present invention did not cause film defects, retained a high strength, that is, a shear strength of 70 MPa or more, and also had denseness of more than 91%. An SEM image of Example 5 at a magnification of 2000 was shown in Fig. 10. Among them, it was also found that the denseness reached 93% as shown in Example 5, and it was also found that there was a more suitable composition. In the composition shown in Comparative Example 4, since the silver particles A were excessive, shrinkage and generation of voids presumed to be derived from outgas were observed in some places. An SEM image of Comparative Example 4 at a magnification of 1000 including a defective portion was shown in Fig. 11. Although denseness of the portion having no voids and the like was as high as 94%, it is speculated that when a film became thick, there was no escape place for outgas derived from microparticles, and voids were easily generated.

[Table 7]

| | Sintered body (sintering temperature 200°C) | | |
| --- | --- | --- | --- |
| | Shear strength (MPa) | Specific resistance value ($\mu\Omega\cdot$cm) | Film defect |
| Comparative Example 5 | 13 | Cracking | × |
| Comparative Example 6 | 54 | 2.7 | × |
| Comparative Example 7 | 93 | 3.2 | × |
| Comparative Example 8 | 40 | 4.8 | × |

As shown in Fig. 7, it was found from Comparative Examples 5, 6, 7, and 8 that even when microparticles having high sinterability as the silver particles A and the other particles were combined, defective portions are likely to occur unless optimized. For example, it is found that a combination of relatively small particles having high sinterability as in Comparative Example 5 causes adverse effects due to shrinkage. In the case of a combination of particles having high sinterability and coarse particles having small shrinkage as in Comparative Example 8, the shear strength was as low as 40 MPa, and the specific resistance value was also a resistance value as high as 4.8 $\mu\Omega\cdot$cm. It is found that this is not a composition capable of appropriately filling gaps between particles even if a large amount of microparticles are present, and that generation of shrinkage due to film defects cannot be prevented. As shown from this result, it is suggested that a thick film-joined body having high denseness is difficult to form under a non-pressurized condition only with particles having high sinterability, and it is considered that it is important to combine a plurality of silver particles with a suitable composition.

<Voids of Sintered Body (Sintering Temperature 200°C)>

An SEM image of each sintered body obtained in <Production of Sintered Body (Sintering Temperature 200°C)> was acquired in the same manner as in the above <Observation with Electron Microscope>, each SEM image was subjected to image processing (analysis of void portions in the binarized image as particles by automatic reading of color difference) using image analysis type particle size distribution measurement software (Macview) (manufactured by Mountech Co., Ltd.), the number average size and specific surface area of voids of the sintered body were calculated. The results are shown in Table 8. The number average size described herein is analyzed by image analysis software (Macview) assuming that the void is a sphere, and the specific surface area value is determined by calculating the surface area per unit volume of the sphere. The number average size and specific surface area of voids of Examples 1 to 6 are shown in Table 8.

[Table 8]

| | Voids of sintered body (sintering temperature 200°C) | |
| --- | --- | --- |
| | Number average size ($\mu$m) | Specific surface area ($\mu$m$^2$) |
| Example 1 | 0.49 | 0.19 |
| Example 2 | 0.49 | 0.17 |

(continued)

| | Voids of sintered body (sintering temperature 200°C) | |
|---|---|---|
| | Number average size ($\mu$m) | Specific surface area ($\mu$m$^2$) |
| Example 3 | 0.53 | 0.22 |
| Example 4 | 1.04 | 0.82 |
| Example 5 | 0.99 | 0.53 |
| Example 6 | 0.50 | 0.18 |

**Claims**

1. An electroconductive adhesive comprising:

   silver particles A having an average particle size of less than 40 nm;
   silver particles B having an average particle size in a range of 40 nm or more to less than 500 nm;
   silver particles C having an average particle size in a range of 0.5 $\mu$m or more to less than 5.5 $\mu$m; and
   a solvent,
   wherein a mass ratio of the silver particles A : the silver particles B : the silver particles C is 1 to 20 : 30 to 60 : 40 to 70.

2. The electroconductive adhesive according to claim 1, wherein an amine compound is attached to surfaces of the silver particles A and/or the silver particles B.

3. A sintered body of the electroconductive adhesive according to claim 1 or 2.

4. An electronic component formed by joining members by the sintered body according to claim 3.

5. A method for producing a sintered body, the method comprising a step of sintering the electroconductive adhesive according to claim 1 or 2 at a temperature of 200°C or higher and 250°C or lower.

6. A method for manufacturing an electronic component formed by joining members by a sintered body, the method comprising:

   a step of disposing the electroconductive adhesive according to claim 1 or 2 between the members; and
   a step of sintering the electroconductive adhesive at a temperature of 200°C or higher and 250°C or lower.

FIG. 1

FIG. 2

FIG. 3

FIG. 4

FIG. 5

FIG. 6

FIG. 7

FIG. 8

SED 20.0 kV WD 22.8 mm Std.-PC 70.0 HighVac x2,000 10 µm
STD 0200 2019 10 04 #E433-1

FIG. 9

SED 20.0 kV WD 22.8 mm Std.-PC 70.0 HighVac x200 100 µm
STD 0197 2019 10 04 #E433-1

FIG. 10

FIG. 11

## INTERNATIONAL SEARCH REPORT

| International application No. |
|---|
| **PCT/JP2021/031411** |

### A. CLASSIFICATION OF SUBJECT MATTER

*C09J 1/00*(2006.01)i; *C09J 9/02*(2006.01)i; *H01B 1/00*(2006.01)i; *H01B 1/22*(2006.01)i; *H01L 21/52*(2006.01)i
FI: C09J1/00; C09J9/02; H01B1/22 D; H01B1/00 K; H01B1/00 E; H01L21/52 E

According to International Patent Classification (IPC) or to both national classification and IPC

### B. FIELDS SEARCHED

Minimum documentation searched (classification system followed by classification symbols)

C09J1/00; C09J9/02; H01B1/00; H01B1/22; H01L21/52

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2013/108408 A1 (DOWA ELECTRONICS MATERIALS CO., LTD) 25 July 2013 (2013-07-25) claims, paragraphs [0002]-[0013], [0026]-[0027], [0034]-[0035], [0037], examples 1-3 | 1, 3-6 |
| Y | | 1-6 |
| Y | WO 2014/185073 A1 (BANDO CHEMICAL INDUSTRIES, LTD) 20 November 2014 (2014-11-20) claims, paragraphs [0011], [0022]-[0028], examples 1-4, 6-7 | 1-6 |
| A | JP 2004-111254 A (ASAHI GLASS CO LTD) 08 April 2004 (2004-04-08) | 1-6 |
| A | JP 2011-94223 A (MITSUBOSHI BELTING LTD) 12 May 2011 (2011-05-12) | 1-6 |
| A | JP 2011-175871 A (OSAKA MUNICIPAL TECHNICAL RESEARCH INSTITUTE) 08 September 2011 (2011-09-08) | 1-6 |
| A | JP 2016-54098 A (HITACHI CHEMICAL CO LTD) 14 April 2016 (2016-04-14) | 1-6 |
| P, A | WO 2021/044817 A1 (OSAKA SODA CO LTD) 11 March 2021 (2021-03-11) | 1-6 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 October 2021** | **19 October 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2021/031411**

| Patent document cited in search report | | | Publication date (day/month/year) | Patent family member(s) | Publication date (day/month/year) |
|---|---|---|---|---|---|
| WO | 2013/108408 | A1 | 25 July 2013 | US 2015/0028085 A1 claims, paragraphs [0002]-[0014], [0035]-[0036], [0043]-[0044], [0046], examples 1-3 EP 2805783 A1 CN 104066534 A KR 10-2014-0101863 A | |
| WO | 2014/185073 | A1 | 20 November 2014 | US 2016/0121432 A1 claims, paragraphs [0012], [0028]-[0035], examples 1-4, 6-7 EP 2998050 A1 | |
| JP | 2004-111254 | A | 08 April 2004 | (Family: none) | |
| JP | 2011-94223 | A | 12 May 2011 | (Family: none) | |
| JP | 2011-175871 | A | 08 September 2011 | (Family: none) | |
| JP | 2016-54098 | A | 14 April 2016 | (Family: none) | |
| WO | 2021/044817 | A1 | 11 March 2021 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 201018712 A
- JP 2015159096 A
- JP 5574761 B